# EUROPEAN PATENT APPLICATION

(11) **EP 4 152 413 A1**
(43) Date of publication of application: **22.03.2023**
(21) Application number: 21196866.4
(22) Date of filing: 15.09.2021
(51) Int. Cl.: H01L 29/861, H01L 29/06, H01L 29/36, H01L 21/329, H01L 29/16

(54) **POWER DIODE AND METHOD FOR PRODUCING A POWER DIODE**

(71) Applicant: Hitachi Energy Switzerland AG, 5400 Baden (CH)
(72) Inventor: VITALE, Wolfgang Amadeus, 5000 Aarau (CH); NIDA, Selam, 8057 Zurich (CH)
(74) Representative: Epping - Hermann - Fischer

(57) **Abstract**

A power diode (1) comprising a wafer having a cathode side (4) and an anode side (5) opposite to the cathode side (4) is provided, with
- a base layer (2) of a first conductivity type,
- an anode region (6) of a second conductivity type being different from the first conductivity type provided in the wafer at the anode side, and
- a termination region (7) provided in the wafer between the cathode side (4) and the anode side (5), wherein
- the termination region (7) surrounds the anode region (6) in lateral directions,
- the termination region (7) comprises a first pocket (8) of the second conductivity type and at least two second pockets (9) of the second conductivity type,
- the first pocket (8) is provided between the anode region (6) and the at least two second pockets (9) in lateral directions, and
- the first pocket (8) has a first maximum doping concentration being smaller than a second maximum doping concentration of each of the at least two second pockets (9).

Further, a method for producing a power diode (1) is provided.

## Description

Embodiments of the disclosure relate to a power diode, which has an improved efficiency. Further embodiments of the disclosure relate to a method for producing a power diode.

This is achieved by the subject matter of the independent claims. Further embodiments are evident from the dependent claims in the following description.

A first aspect relates to a power diode. The term "power" here and in the following, for example, refers to power diode for processing voltages of more than 100 volts, exemplarily more than 1000 volts.

According to the embodiment of the first aspect, the power diode comprises a wafer having a cathode side and an anode side opposite to the cathode side, with a base layer of a first conductivity type. For example, the wafer, exemplarily the base layer, comprises a semiconductor material or consists of a semiconductor material. Exemplarily, the semiconductor material is based on silicon or a wide bandgap material such as silicon carbide (SiC). Further, the first conductivity type is, for example, an n-conductivity type. For example, the base layer comprises dopants, wherein the dopants are n-type dopants.

A maximum doping concentration of the base layer is, for example, at least 5 x 10¹² cm⁻³ and at most 5 x 10¹⁴ cm⁻³. Exemplarily, the base layer has a homogeneous doping concentration.

The base layer has, for example, a main extension plane. For example, lateral directions are aligned parallel to the main extension plane and a vertical direction is aligned perpendicular to the main extension plane.

Further, the base layer comprises a first main side facing the anode side and a second main side facing the cathode side.

For example, the power diode comprises a buffer layer of the first conductivity type provided on the second main side of the base layer. For example, the buffer layer comprises a semiconductor material or consists of a semiconductor material, which can be based on silicon. Exemplarily, the semiconductor material of the base layer and the semiconductor material of the buffer layer are the same. For example, the buffer layer comprises further dopants.

For example, a maximum doping concentration of the buffer layer is higher than the maximum doping concentration of the base layer. The maximum doping concentration of the buffer layer is, for example, at least one order of magnitude higher than the maximum doping concentration of the base layer.

For example, the buffer layer is configured for being electrically contacted with a cathode electrode. For example, the cathode electrode comprises or consists of a metal. In this case, the cathode electrode is formed of a metal layer being in direct contact with the buffer layer. For example, the cathode electrode completely covers the buffer layer at the second main side. Exemplarily, the cathode electrode is configured for being externally contactable.

According to the embodiment of the first aspect, the power diode comprises an anode region of a second conductivity type being different from the first conductivity type provided in the wafer at the anode side. For example, the anode region, i.e. a top surface of the anode region, terminates flush with the second main side of the base layer. This is to say that exemplarily the anode region does not protrude beyond the second main side of the base layer in vertical direction.

The second conductivity type is exemplarily a p-conductivity type. For example, the anode region comprises dopants, wherein the dopants are p-type dopants.

For example, the anode region is configured for being electrically contacted with an anode electrode. For example, the anode electrode comprises or consists of a metal. In this case, the anode electrode is formed of a metal layer being in direct contact with the anode region. For example, the anode electrode does not protrude beyond the anode region in lateral directions. Exemplarily, the anode electrode is configured for being externally contactable.

According to the embodiment of the first aspect, the power diode comprises a termination region provided in the wafer between the cathode side and the anode side. Exemplary, the termination region extends from the cathode side to the anode side. For example, the termination region, i.e. a top surface of the termination region, terminates flush with the second main side of the base layer.

According to the embodiment of the first aspect, the termination region is surrounding the anode region in lateral directions. For example, the termination region and the anode region do not overlap with one another in planar view in lateral directions. "Planar view" corresponds to a direction in vertical direction, e.g. facing the anode side.

According to the embodiment of the first aspect, the termination region comprises a first pocket of the second conductivity type and at least two second pockets of the second conductivity type. For example, the first pocket extends in the wafer from the anode side towards the cathode side. Likewise, the at least two second pockets extend in the wafer from the anode side towards the cathode side. For example, the first pocket and the second pockets each have a distance from the cathode side. The first pocket and the at least two second pockets, i.e. their top surfaces, exemplary terminate flush with the second main side of the base layer.

According to the embodiment of the first aspect, the first pocket is provided between the anode region and the at least two second pockets in lateral directions.

According to the embodiment of the first aspect, the first pocket has a first maximum doping concentration being smaller than a second maximum doping concentration of each of the at least two second pockets.

For example, the first maximum doping concentration is at least 5 x 10¹⁵ cm⁻³ and at most 5 x 10¹⁸ cm⁻³. Further, the second maximum doping concentration is, for example, at least 5 x 10¹⁵ cm⁻³ and at most 1 x 10¹⁹ cm⁻³.

For example, in the off state, the power diode blocks an applied voltage, being applied vertically between the first main side and the second main side.

However, in an edge region of the power diode, a stray electric field can emerge and can cause undesired breakdown. For example, due to the termination region, the stray electric field decay in lateral directions from the anode region to the edge region of the power diode.

Further, due to the first pockets, this electric field can be decreased even more. Moreover, power dissipation can be decreased. Furthermore, a width of the termination region can be reduced due to the first pocket, while still blocking the applied voltage.

According to at least one embodiment of the power diode, the at least two second pockets are spaced apart from one another in lateral directions. Exemplarily, the at least two second pockets are not in direct contact with one another and do not overlap with one another in planar view in lateral directions.

According to at least one embodiment of the power diode, the first pocket and the at least two second pockets are spaced apart from one another in lateral directions. This is to say that the first pocket and the direct neighbouring second pocket exemplarily are not in direct contact with one another and do not overlap with one another in planar view in lateral directions.

According to at least one embodiment of the power diode, the first pocket and the at least two second pockets each completely surround the anode region in lateral directions.

The first pocket and the at least two second pockets surround the anode region in a frame-like manner. In a frame-like manner means here and in the following that the first pocket and the at least two second pockets, completely surround the anode region in lateral directions independently form their shape.

For example, the anode region has, in planar view, an oval shape, a circular shape, or a polygonal shape such as a rectangular shape. In case of a polygonal shape, edges of the polygonal shape can be rounded. The shapes of the first pocket and the at least two second pockets is the same, for example. The diameter or the edge length of the shape exemplarily increases from the first pocket to an outer second pocket of the second pockets.

According to at least one embodiment of the power diode, the anode region and the at least two second pockets each comprise a first doped region and a second doped region. For example, the first doped region comprises a first dopant and the second doped region comprises a second dopant. For example, the first dopant and the second dopant are the same. Exemplarily, the first dopant and the second dopant are p-type dopants.

According to at least one embodiment of the power diode, a maximum doping concentration of the first doped region is higher than a maximum doping concentration of the second doped region. Exemplarily, the maximum doping concentration of the first doped region equals the first maximum doping concentration and the maximum doping concentration of the second doped region equals the second maximum doping concentration.

According to at least one embodiment of the power diode, the first doped region extends in vertical direction to a first depth in the wafer from the anode side. For example, the first doped region extends from the anode side of the base layer in direction to the cathode side in vertical direction, wherein the first doped region is distanced to the cathode side.

For example, the first depth is at least 5 µm and at most 15 µm.

According to at least one embodiment of the power diode, the second doped region extends in vertical direction to a second depth in the wafer from the anode side. For example, the second doped region extends from the anode side in direction to the cathode side in vertical direction wherein the second doped regions are distanced to the cathode side.

For example, the second depth is at most 2 µm.

According to at least one embodiment of the power diode, the first depth is larger than the second depth. For example, a width of the first doped region is larger than a width of the second doped region in lateral directions. This is to say that the second doped region is exemplarily embedded in the first doped region. Embedded means here and in the following that an outer surface of the second doped region facing the base layer is completely covered by the first doped region.

According to at least one embodiment of the power diode, a width of the anode region is larger than a width of the first pocket and larger than a width of each of the at least two second pockets in lateral directions. The widths are each defined by a minimal extent of the corresponding element in lateral directions.

For example, the width of the first pocket is at most 25 % of the width of the anode region.

According to at least one embodiment of the power diode, a width of the first pocket is larger than the width of each of the at least two second pockets in lateral directions.

For example, the width of the at least two second pockets are at most 25 % of the width of the first pocket.

According to at least one embodiment of the power diode, the power diode further comprises a cathode electrode and an anode electrode, wherein the cathode electrode is provided on the wafer from the cathode side and the anode electrode is provided on the anode region.

According to at least one embodiment of the power diode, the anode electrode completely overlaps with the second doped region of the anode region in planar view. Further, the anode electrode is in direct contact with the second doped region of the anode region.

According to at least one embodiment of the power diode, the first maximum doping concentration of the first pocket is at least one order of magnitude smaller than the second maximum doping concentration of each of the at least two second pockets.

A second aspect relates to a method for producing a power diode. Exemplarily, the method produces a power diode described herein above. All features disclosed in connection with the power diode are therefore also disclosed in connection with the method and vice versa.

According to the embodiment of the second aspect of the method, a base layer of a first conductivity type different from a second conductivity type is provided.

For example, a buffer layer of the first conductivity type is generated from a cathode side.

According to the embodiment of the second aspect of the method, an anode region pocket and at least three zones are generated by introducing a first dopant of the second conductivity type in the wafer from the anode side, such that each zone has a first maximum doping concentration in the wafer.

The first dopant is incorporated on or in the wafer, e.g. the base layer, e.g. by at least one of an ion implantation or a deposition process, which may be followed by a diffusion process.

According to the embodiment of the second aspect of the method, a second dopant of the second conductivity type are introduced in the anode region pocket and in the at least three zones such that an anode region and at least two second pockets are generated having a second maximum doping concentration.

The second dopant is incorporated on or in the wafer, e.g. the base layer, e.g. by at least one of an ion implantation or a deposition process, which may be followed by a diffusion process.

According to the embodiment of the second aspect of the method, the zone in which no second dopant is introduced is arranged between the anode region and the at least two second pockets, forming a first pocket.

According to the embodiment of the second aspect of the method, the first maximum doping concentration is smaller than the second maximum doping concentration.

According to at least one embodiment of the method, a first mask having at least four openings is applied on the anode side before introducing the first dopant. For example, one of the openings has the shape corresponding to the anode region to be produced, another one of the openings has the shape corresponding to the first pocket to be produced and the others of the openings have the shape corresponding to the second pockets to be produced.

According to at least one embodiment of the method, a second mask having one opening less than the first mask is applied to the first mask before introducing the second dopant, wherein the second mask covers the zone closest to the anode region pocket. This is to say that the anode region as well as the at least two second pockets each comprise the first doped region and the second doped region with the first dopant of the first maximum doping concentration and the second dopant with the second maximum doping concentration, for example. The first pocket exemplarily solely comprises the first doped region with the first dopant.

According to at least one embodiment of the method, the first mask is an oxide mask.

According to at least one embodiment of the method, the first mask is removed after the generation of the anode region and the at least two second pockets. E.g. the first mask and the second mask are removed after the generation of the anode region and the at least two second pockets.

According to at least one embodiment of the method, a cathode electrode and a anode electrode are produced after the generation of the anode region and the at least two second pockets.

The embodiments will be explained in more detail in the following with references to exemplary embodiments which are illustrated in the attached Figures.
Figure 1 schematically shows a sectional view of a power diode according to an exemplary embodiment.
Figure 2 schematically shows a plan view of a power diode according to an exemplary embodiment.
Figure 3 schematically shows a doping concentration of an exemplary power diode and a termination region of a power diode according to an exemplary embodiment.
Figures 4 and 5 schematically show a peak current density and a peak electric field, respectively, during switching of an exemplary power diode and a power diode according to an exemplary embodiment.
Figure 6 schematically shows a power density of an exemplary power diode and a power diode according to an exemplary embodiment.
Figure 7 schematically shows a dynamic power dissipation of an exemplary power diode and a power diode according to an exemplary embodiment.
Figure 8, 9 and 10 schematically show method steps of a method for producing a power diode according to an exemplary embodiment.

The reference symbols used in the drawings and their meaning are listed in summary form in the list of reference symbols. In principle, identical parts are provided with the same reference symbols in the figures.

The power diode 1 comprises a wafer, e.g. being a semiconductor body, with an anode side 5 and a cathode side 4 opposite to the anode side 5. The wafer comprises a base layer 2 of a first conductivity type. The base layer 2 has a first main side facing the anode side 5 and a second main side facing the cathode side 4. For example, the semiconductor body further comprises a buffer layer 3 of the first conductivity type, provided on the cathode side 4 of the semiconductor body, electrically connected to the second main side of the base layer 2.

Both, the buffer layer 3 and the base layer 2 comprise n-type dopant and thus the first conductivity type is of an n-conductivity type. A maximum doping concentration of the buffer layer 3 is higher than the maximum doping concentration of the base layer 2.

In addition, the power diode 1 comprises a cathode electrode 10 being provided from the cathode side 4.

At the anode side 5, an anode region 6 of a second conductivity type being different from the first conductivity type is provided in the wafer. The anode region 6 comprises a first doped region 15 extending in the wafer from the anode side 5 in vertical direction to a first depth and a second doped region 16 extending in the wafer from the anode side 5 in vertical direction to a second depth. The first depth is larger than the second depth.

Furthermore, a width of the first doped region 15 of the anode region 6 is larger than a width of the second doped region 16 of the anode region 6. A top surface, facing away from the base layer 2, of the first doped region 15 of the anode region 6 and a top surface of the second doped region 16 of the anode region 6 terminate flush with one another. Furthermore, the top surfaces and a second main side of the base layer 2, facing away from the buffer layer 3, terminate flush with one another. This is to say that the top surfaces and the second main side are in a common plane extending in lateral directions.

Both, the first doped region 15 and the second doped region 16 comprise p-type dopants and thus the second conductivity type is of a p-conductivity type. A first maximum doping concentration of the first doped region 15 is smaller than a second maximum doping concentration of the second doped region 16. For example, the maximum doping concentration of the first doped region 15 is at least one order of magnitude smaller than a second maximum doping concentration of the second doped region 16.

For example, the first maximum doping concentration is between 5 x 10¹⁵ cm⁻³ and 5 x 10¹⁸ cm⁻³, and the second maximum doping concentration is comprised between 5 x 10¹⁶ cm⁻³ and 5 x 10¹⁹ cm⁻³.

In addition, an anode electrode 11 is provided on the anode region 6 at the first main side 5. The anode electrode 11 does not protrude beyond the anode region 6 in lateral directions. The anode electrode 11 is in direct electric contact with the second doped region 16 of the anode region 6 and not with the second doped regions 16 of the termination region 7.

Further, the anode electrode 11 completely overlaps with the second doped region 16 of the anode region 6 in lateral directions. Here, the second doped region 16 protrudes beyond the anode electrode 11 in lateral directions.

Alternatively, it is possible that the anode electrode 11 protrudes beyond the second doped region 16 in lateral directions such that the anode electrode 11 completely covers the top surface of the second doped region 16 of the anode region 6.

Further, the power diode 1 comprises a termination region 7 being provided in the wafer from the anode side 5. The termination region 7 comprises a first pocket 8 of the second conductivity type and two second pockets 9 of the second conductivity type. The first pocket 8 exclusively comprises the first doping region 15 with the first maximum doping concentration extending in vertical direction to the first depth. The two second pockets 9 each comprises the first doping region 15 with the first maximum doping concentration, also extending in vertical direction to the first depth, and the second doping region 16 with the second maximum doping concentration, extending in vertical direction to the second depth. This is to say that the first pocket 8 has the first maximum doping concentration being smaller than the second maximum doping concentration of each of the two second pockets 9.

Each width of the first doped regions 15 of the two second pockets 9 is larger than a width of the second doped regions 16 of the two second pockets 9. Furthermore, top surfaces of the first doped regions 15 of the first pocket 8 and the two second pockets 9 and top surfaces of the second doped regions 16 of the two second pockets 9 terminate flush with one another. Furthermore, the top surfaces and the second main side of the base layer 2 terminate flush with one another.

In lateral directions, the first pocket 8 is provided between the anode region 6 and the two second pockets 9. Furthermore, the first pocket 8, the two second pockets 9 and the anode region 6 are spaced apart from one another in lateral directions.

The first pocket 8 is also called resistive region, since it helps to reduce the peak electric field as well as the peak current density within the region of the first pocket 8.

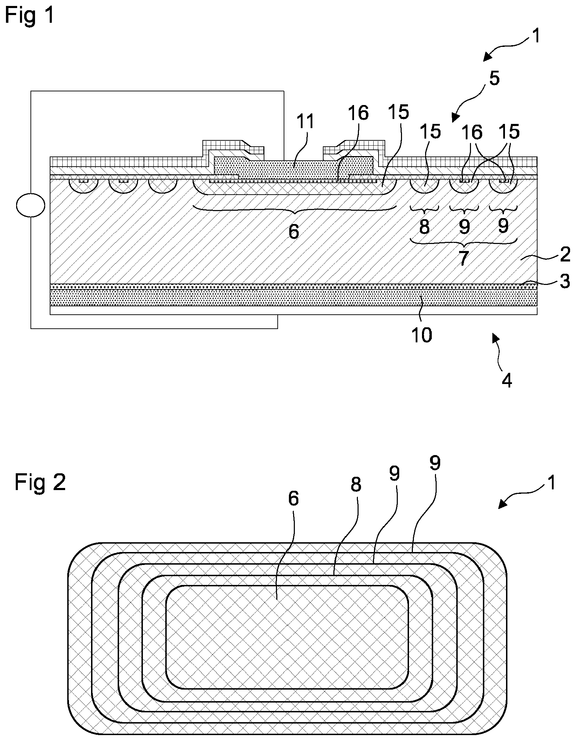

The termination region 7 completely surrounds the anode region 6 in lateral directions, according to Figure 2. The first pocket 8 and the two second pockets 9 completely surround the anode region 6 in a frame like manner.

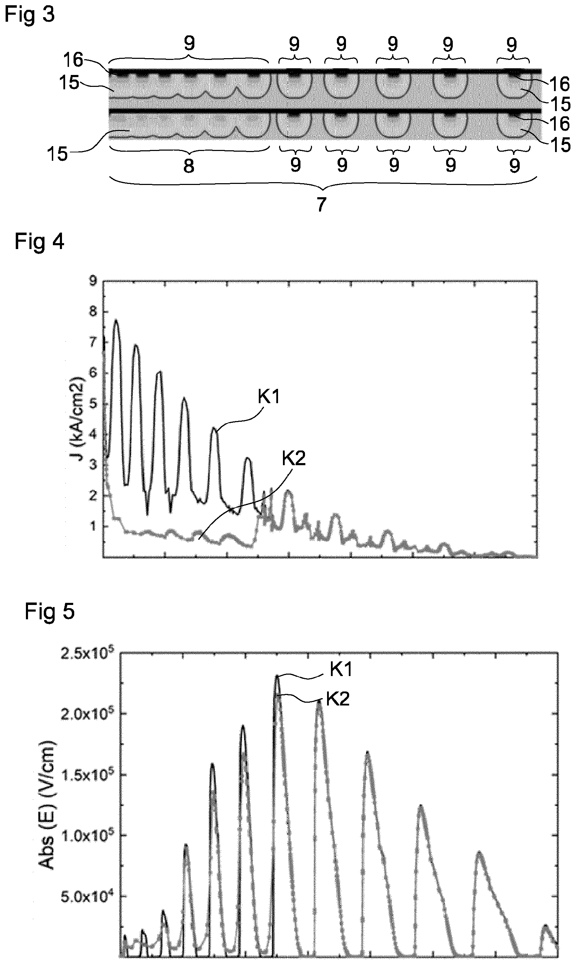

The doping concentration in [cm⁻³] shown in the upper part of Figure 3 is representative for an exemplary power diode. The exemplary power diode comprises a termination region 7, which exclusively comprises second pockets 9 having first doped regions 15 and second doped regions 16.

In contrast, the termination region 7 in [cm⁻³] of the power diode 1 according an exemplary embodiment, shown in the lower part of Figure 3, comprises a first pocket 8. The first pocket 8 exclusively comprises the first doped region 15. Furthermore, the first doped pocket has a width in lateral direction being larger than each of the widths of each of the second pockets 9. A distance between the second pockets 9 can be increased in direction to an edge of the power diode 1.

In the diagram according to Figure 4 shows a peak current density J in [kA/cm²] during switching from the ON state to the OFF state of a power diode 1 having doping concentrations according to Figure 3 at the level of a the second main side. The x-axis corresponds to the lateral extend shown in Figure 3. The first curve K1 corresponds to a doping concentration of an exemplary power diode 1, in particular shown in the upper part of Figure 3. The second curve K2 corresponds to a doping concentration of a power diode, according to an exemplary embodiment, in particular shown in the lower part of Figure 3.

In the diagram according to Figure 5, a peak electric field E in [V/cm] is shown, which corresponds to the peak current density J of Figure 4.

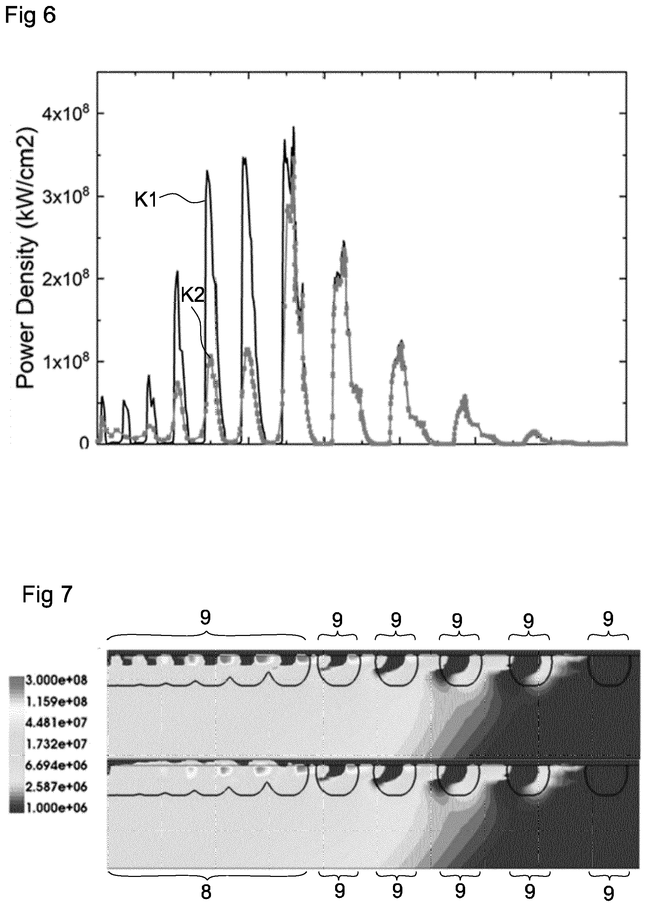

In the diagram according to Figure 6, a power density P in [kW/ cm²] is shown, which corresponds to the diagrams of Figures 4 and 5.

The power dissipation in [kW/cm²], shown in the upper part of Figure 7, is representative for an exemplary power diode according to the exemplary power diode according to Figure 3.

In contrast, the power dissipation, shown in the lower part of Figure 7, is representative for a power diode 1 according an exemplary embodiment, e.g. shown in the lower part of Figure 3.

The power dissipation according to Figure 7 corresponds to the power dissipation of the diagram of Figure 6.

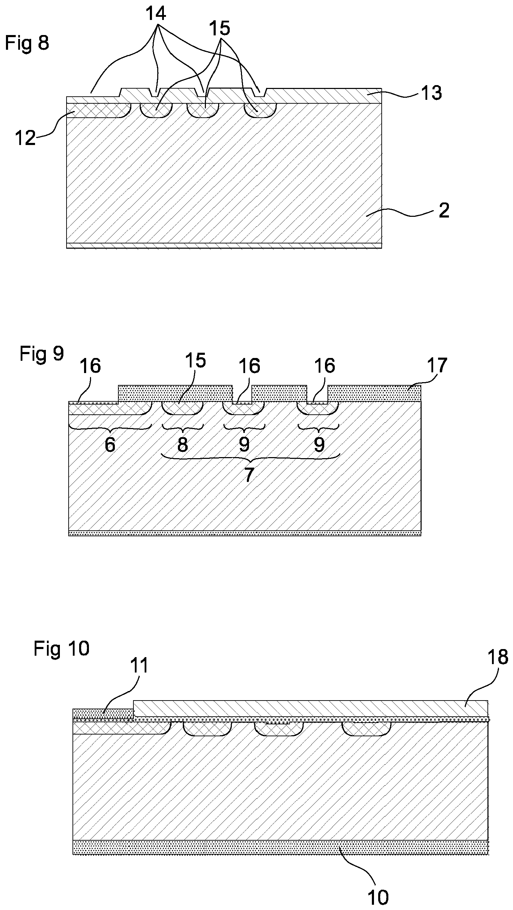

The method for producing a power diode 1 according to Figures 8, 9 and 10 comprises that a first mask 13 is applied to a second main side of the base layer 2. The first mask 13 has four openings 14.

According to Figure 8, an anode region pocket 12 and three zones are generated by introducing a first dopant of the second conductivity type with a first maximum doping concentration in the base layer 2 from a first main side of the base layer 2 being opposite the second main side. This is to say that the first dopant is introduced through the openings 14 of the first mask 13 in the base layer 2 to a first depth. This results in the anode region pocket 12 and the three zones having the first maximum doping concentration.

Depending on the process for introducing the first dopant, a concentration of the first dopant can decrease continuously in direction to the cathode side 4. This is to say that the first maximum doping concentration is located close to the top surface of the respective zones or pockets.

Subsequently, according to Figure 9, a second mask 17 is provided on the first mask 13, wherein the second mask 17 has one opening 14 less than the first mask 13. This is to say that the second mask 17 has three openings 14, wherein the openings 14 of the second mask 17 each have a smaller width than the openings 14 of the first mask 13. Further, the second mask 17 covers the zone closest to the anode region pocket 12.

Further, a second dopant is introduced through the openings 14 of the second mask 17 in the anode region pocket 12 and two of the three zones to a second depth. This results in the anode region 6 and the two second pockets 9 having the second maximum doping concentration.

After the generation of the anode region 6 and the two second pockets 9, a passivation region 18, comprising at least one passivation layer, may be created on the base layer 2 comprising one opening 14, wherein the opening 14 of the passivation region 18 is arranged above the second doped region 16 of the anode region 6. The opening 14 of the passivation region 18 is smaller than the corresponding opening 14 of the second mask 17.

Through the opening 14 of the third mask 18, a anode electrode 11 is deposited on the second doped region 16 of the anode region 6. Further, a cathode electrode 10 is deposited on the cathode side 4.

The passivation region 18, e.g. the at least one passivation layer is formed by standard photolithography techniques after forming the anode electrode 11. Exemplarily, the anode electrode 11 is formed by blanket deposition and subsequent etching by standard photolithography technics.

### Reference Signs

- 1: power diode
- 2: base layer
- 3: buffer layer
- 4: cathode side
- 5: anode side
- 6: anode region
- 7: termination region
- 8: first pocket
- 9: second pocket
- 10: cathode electrode
- 11: anode electrode
- 12: anode region pocket
- 13: first mask
- 14: opening
- 15: first doped region
- 16: second doped region
- 17: second mask
- 18: third mask

- K1: first curve
- K2: second curve

## Claims

1. A power diode (1) comprising a wafer having a cathode side (4) and an anode side (5) opposite to the cathode side, with
- a base layer (2) of a first conductivity type,
- an anode region (6) of a second conductivity type being different from the first conductivity type provided in the wafer at the anode side, and
- a termination region (7) provided in the wafer between the cathode side (4) and the anode side (5), wherein
- the termination region (7) surrounds the anode region (6) in lateral directions,
- the termination region (7) comprises a first pocket (8) of the second conductivity type and at least two second pockets (9) of the second conductivity type,
- the first pocket (8) is provided between the anode region (6) and the at least two second pockets (9) in lateral directions, and
- the first pocket (8) has a first maximum doping concentration being smaller than a second maximum doping concentration of each of the at least two second pockets (9).

2. The power diode (1) according to claim 1, wherein
- the at least two second pockets (9) are spaced apart from one another in lateral directions, and
- the first pocket (8) and the at least two second pockets (9) are spaced apart from one another in lateral directions.

3. The power diode (1) according to one of the claims 1 or 2, wherein
- the first pocket (8) and the at least two second pockets (9) each completely surrounds the anode region (6) in lateral directions.

4. The power diode (1) according to one of the claims 1 to 3, wherein
- the anode region (6) and the at least two second pockets (9) each comprises a first doped region (15) and a second doped region (16),
- a maximum doping concentration of the first doped region (15) is higher than a maximum doping concentration of the second doped region (16).

5. The power diode (1) according to claim 4, wherein
- the first doped region (15) extends in a vertical direction to a first depth in the wafer from the anode side (5),
- the second doped region (16) extends in vertical direction to a second depth in the wafer from the anode side, and
- the first depth is larger than the second depth.

6. The power diode (1) according to one of the claims 1 to 5, wherein
- a width of the anode region (6) is larger than a width of the first pocket (8) and larger than a width of each of the at least two second pockets (9) in lateral directions.

7. The power diode (1) according to one of the claims 1 to 6, wherein
- a width of the first pocket (8) is larger than a width of each of the at least two second pockets (9) in lateral directions.

8. The power diode (1) according to one of the claims 1 to 7, wherein the power diode (1) further comprises
- a cathode electrode (10), and
- a anode electrode (11), wherein
- the cathode electrode (10) is provided on the wafer from the cathode side (4), and
- the anode electrode (11) is provided on the anode region (6) .

9. The power diode (1) according to claim 4 and 8, wherein
- the anode electrode (11) completely overlaps with the second doped region (16) of the anode region (6) in planar view.

10. The power diode (1) according to one of the claims 1 to 9, wherein
- the first maximum doping concentration of the first pocket (8) is at least one order of magnitude smaller than the second maximum doping concentration of each of the least two second pockets (9).

11. A method for producing a power diode (1) comprising a wafer having a cathode side (4) and an anode side (5) opposite to the cathode side (4), with:
- providing a base layer (2) of a first conductivity type different from a second conductivity type,
- generating an anode region pocket (12) and at least three zones by introducing a first dopant of the second conductivity type from the anode side (5) in the wafer, such that each zone has a first maximum doping concentration in the wafer,
- introducing a second dopant of the second conductivity type in the anode region pocket (12) and in the at least two of the at least three zones such that an anode region (6) and at least two second pockets (9) having a second maximum doping concentration are generated, wherein
- the zone in which no second dopant is introduced is arranged between the anode region (6) and the at least two second pockets (9) forming a first pocket (8), and
- the first maximum doping concentration is smaller than the second maximum doping concentration.

12. The method according to claim 11, wherein
- applying a first mask (13) having at least four openings (14) on the anode side (5) before introducing the first dopant, and
- applying a second mask (17) to the first mask (13) having one opening less than the first mask (13) before introducing the second dopant, wherein the second mask (17) covers the zone closest to the anode region pocket (12).

13. The method according to claim 12, wherein
- the first mask (13) is an oxide mask.

14. The method according to of the claims 12 to 13 wherein
- removing the first mask (13) after the generation of the anode region (6) and the at least two second pockets (9).

15. The method according to one of the claims 11 to 14, wherein
- producing a cathode electrode (10) and an anode electrode (11) after the generation of the anode region (6) and the at least two second pockets (9).
